# EUROPEAN PATENT APPLICATION

(11) **EP 4 436 338 A2**
(43) Date of publication of application: **25.09.2024**
(21) Application number: 24153266.2
(22) Date of filing: 22.01.2024
(51) Int. Cl.: H10K 59/121, H10K 59/126

(54) **DISPLAY APPARATUS**

(30) Priority: 24.03.2023 KR 20230038983; 09.05.2023 KR 20230059903
(71) Applicant: Samsung Display Co., Ltd., Yongin-si, Gyeonggi-do 17113 (KR)
(72) Inventor: HYUN, Chaehan, 17113 Yongin-si (KR); KA, Jihyun, 17113 Yongin-si (KR); KWAK, Wonkyu, 17113 Yongin-si (KR)
(74) Representative: Marks & Clerk LLP

(57) **Abstract**

A display apparatus includes first, second, and third sub-pixels, each of which includes a substrate; a driving transistor arranged above the substrate and including a semiconductor layer and a driving gate electrode, the semiconductor layer including a driving active region; a driving shield layer arranged between the substrate and the driving active region; a first capacitor including a first capacitor electrode and a second capacitor electrode, the first capacitor electrode being arranged on a same layer as the driving shield layer, and the second capacitor electrode being arranged on a same layer as the semiconductor layer; and a display element electrically connected to the second capacitor electrode, wherein lengths of the driving active region of the first sub-pixel, the driving active region of the second sub-pixel, and the driving active region of the third sub-pixel are not all the same.

## Description

### BACKGROUND

### 1. Field

Aspects of some embodiments of the present disclosure relate to a display apparatus, and more particularly, to a display apparatus in which a high-quality image may be displayed.

### 2. Description of the Related Art

Recently, display apparatuses have been used in a greater variety of ways. In addition, display apparatuses have become thinner and lighter in weight, and thus, their range of use has widened.

As display apparatuses are used in various ways, various methods may be used to design forms of display apparatuses. In addition, the area occupied by a display area in display apparatuses has been increased, and thus, various functions that may be applied or linked to display apparatuses have been added.

Such display apparatuses may have thin-film transistors, connection electrodes, and wires arranged in each sub-pixel to control the luminance of each sub-pixel.

The above information disclosed in this Background section is only for enhancement of understanding of the background of the invention and therefore it may contain information that does not form the prior art.

### SUMMARY

Aspects of some embodiments are directed to a display apparatus in which a high-quality image may be displayed. However, such a technical objective is merely an example, and embodiments of the present disclosure are not limited thereto.

Additional aspects will be set forth in part in the description which follows and, in part, will be apparent from the description, or may be learned by practice of the presented embodiments of the disclosure.

According to some embodiments of the present disclosure, there is provided a display apparatus including a first sub-pixel, a second sub-pixel, and a third sub-pixel emitting light of different colors from one another, each of the first to third sub-pixels including: a substrate; a driving transistor arranged above the substrate and including a semiconductor layer and a driving gate electrode, the semiconductor layer including a driving active region; a driving shield layer arranged between the substrate and the driving active region; a first capacitor including a first capacitor electrode and a second capacitor electrode, the first capacitor electrode being arranged on a same layer as the driving shield layer, and the second capacitor electrode being arranged on a same layer as the semiconductor layer; and a display element electrically connected to the second capacitor electrode, wherein at least one of a length of the driving active region of the first sub-pixel, a length of the driving active region of the second sub-pixel, and a length of the driving active region of the third sub-pixel is different from other ones of the lengths.

In some embodiments, each of the first to third sub-pixels further includes a first scan line arranged on the same layer as the driving shield layer and extending in a first direction, and the driving active region extends in a second direction crossing the first direction.

In some embodiments, at least one of a length of the driving gate electrode of the first sub-pixel, a length of the driving gate electrode of the second sub-pixel, and a length of the driving gate electrode of the third sub-pixel in the second direction is different from other ones of the lengths.

In some embodiments, the length of the driving active region of the second sub-pixel is greater than the length of the driving active region of the first sub-pixel and the length of the driving active region of the third sub-pixel.

In some embodiments, the length of the driving active region of the first sub-pixel and the length of the driving active region of the third sub-pixel are a same as each other.

In some embodiments, the first sub-pixel is a red pixel, the second sub-pixel is a green pixel, and the third sub-pixel is a blue pixel.

In some embodiments, each of the first to third sub-pixels further includes: an initialization voltage line arranged on the same layer as the driving shield layer; and an initialization transistor connected to the initialization voltage line, wherein the initialization voltage line includes a first initialization voltage line and a second initialization voltage line spaced apart from each other, and wherein the first initialization voltage line is electrically connected to the initialization transistor of one sub-pixel among the first to third sub-pixels, and the second initialization voltage line is electrically connected to the initialization transistors of other two sub-pixels among the first to third sub-pixels.

In some embodiments, a magnitude of a first initialization voltage transferred through the first initialization voltage line is different from magnitude of a second initialization voltage transferred through the second initialization voltage line.

In some embodiments, each of the first to third sub-pixels further includes: a reference voltage line arranged on the same layer as the driving shield layer; and a reference voltage transistor connected to the reference voltage line, wherein the reference voltage line includes a first reference voltage line and a second reference voltage line spaced apart from each other.

In some embodiments, the first reference voltage line is electrically connected to the reference voltage transistor of one sub-pixel among the first to third sub-pixels, and the second reference voltage line is electrically connected to the reference voltage transistors of other two sub-pixels among the first to third sub-pixels.

According to some embodiments of the present disclosure, there is provided a display apparatus including: a substrate; a first sub-pixel including a first pixel circuit including a first driving transistor and a first initialization transistor, the first driving transistor being arranged above the substrate and including a first semiconductor layer, the first semiconductor layer including a first driving active region and a first driving gate electrode; a second sub-pixel including a second pixel circuit including a second driving transistor and a second initialization transistor, the second driving transistor being arranged above the substrate and including a second semiconductor layer, the second semiconductor layer including a second driving active region and a second driving gate electrode; and a horizontal driving voltage line arranged between the substrate and the first semiconductor layer, extending in a first direction, and electrically connected to the first sub-pixel and the second sub-pixel, wherein a size of the first driving gate electrode is different from a size of the second driving gate electrode.

In some embodiments, a length of the first driving gate electrode in a second direction crossing the first direction is different from a length of the second driving gate electrode in the second direction.

In some embodiments, a length of the first driving active region is different from a length of the second driving active region.

In some embodiments, the display apparatus further includes: a third sub-pixel including a third pixel circuit including a third driving transistor and a third initialization transistor, the third driving transistor being arranged above the substrate and including a third semiconductor layer, the third semiconductor layer including a third driving active region and a third driving gate electrode, wherein a size of the third driving gate electrode is a same as the size of the first driving gate electrode.

In some embodiments, the first sub-pixel is a red pixel, the second sub-pixel is a green pixel, and the third sub-pixel is a blue pixel.

In some embodiments, a length of the second driving active region is greater than a length of the first driving active region and a length of the third driving active region.

In some embodiments, the display apparatus further includes a first initialization voltage line and a second initialization voltage line arranged between the substrate and the first semiconductor layer and extending in the first direction, wherein the first initialization voltage line is electrically connected to the second initialization transistor, and the second initialization voltage line is electrically connected to the first initialization transistor and the third initialization transistor.

In some embodiments, the display apparatus further includes a first initialization voltage line and a second initialization voltage line arranged between the substrate and the first semiconductor layer and extending in the first direction, wherein the first initialization voltage line is electrically connected to the second initialization transistor, and the second initialization voltage line is electrically connected to the first initialization transistor.

In some embodiments, the display apparatus further includes a first reference voltage line and a second reference voltage line arranged between the substrate and the first semiconductor layer and extending in the first direction, wherein the first reference voltage line is electrically connected to the first sub-pixel, and the second reference voltage line is electrically connected to the second sub-pixel.

In some embodiments, the first semiconductor layer includes an oxide semiconductor material.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view of a portion of a display apparatus according to some embodiments of the present disclosure;
FIG. 2 is a schematic side view of the display apparatus of FIG. 1, according to some embodiments of the present disclosure;
FIG. 3 is an equivalent circuit diagram of a sub-pixel included in the display apparatus of FIG. 1, according to some embodiments of the present disclosure;
FIG. 4 is a layout diagram schematically showing locations of transistors and capacitors in sub-pixels included in the display apparatus of FIG. 1, according to some embodiments of the present disclosure;
FIGS. 5 to 8 are layout diagrams schematically showing elements, such as the transistors and the capacitors of the display apparatus shown in FIG. 4, layer by layer, according to some embodiments of the present disclosure;
FIG. 9 is a schematic cross-sectional view of the display apparatus shown in FIG. 4, taken along the line I-I' of FIG. 4, according to some embodiments of the present disclosure;
FIG. 10 is a graph simulating a driving current change rate of sub-pixels that changes during a temperature rise, according to the length of a driving active region, according to some embodiments of the present disclosure;
FIG. 11 is a layout diagram schematically showing locations of transistors and capacitors in sub-pixels included in a display apparatus according to some embodiments of the present disclosure;
FIG. 12 is a schematic cross-sectional view of an organic light-emitting diode that may be included in a display apparatus according to some embodiments of the present disclosure;
FIG. 13 is a schematic cross-sectional view of an organic light-emitting diode that may be included in a display apparatus according to some embodiments of the present disclosure;
FIG. 14 is a schematic cross-sectional view of an organic light-emitting diode that may be included in a display apparatus according to some embodiments of the present disclosure; and
FIG. 15 is a schematic cross-sectional view of an organic light-emitting diode that may be included in a display apparatus according to some embodiments of the present disclosure.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present description allows for various changes and numerous embodiments, certain embodiments will be illustrated in the drawings and described in the written description. Effects and features of one or more embodiments and methods of accomplishing the same will become apparent from the following detailed description of the one or more embodiments, taken in conjunction with the accompanying drawings. However, the present embodiments may have different forms and should not be construed as being limited to the descriptions set forth herein.

One or more embodiments will be described below in more detail with reference to the accompanying drawings. Those elements that are the same or are in correspondence with each other are rendered the same reference numeral regardless of the figure number, and redundant descriptions thereof are omitted.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

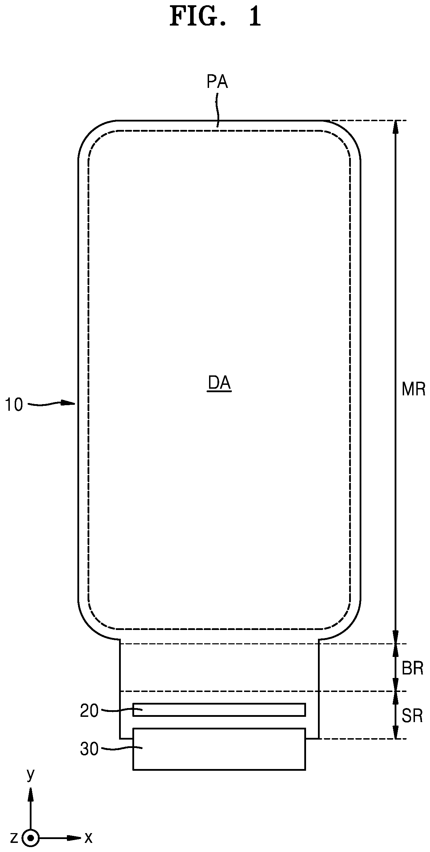

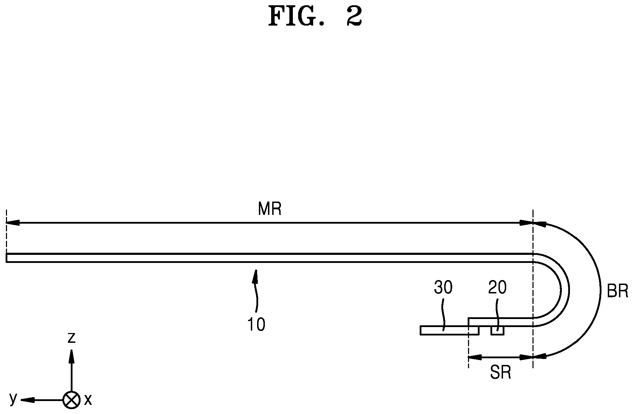

FIG. 1 is a schematic plan view of a portion of a display apparatus according to some embodiments of the present disclosure. FIG. 2 is a schematic side view of the display apparatus of FIG. 1, according to some embodiments of the present disclosure. A portion of the display apparatus may be bent as shown in FIG. 2. However, in FIG. 1, it is shown as not being bent for convenience of illustration.

As shown in FIGS. 1 and 2, the display apparatus according to some embodiments includes a display panel 10. The display apparatus may be any apparatus including the display panel 10. For example, the display apparatus may be part of a variety of products, such as a smartphone, a tablet, a laptop, a television, or a billboard.

The display panel 10 includes a display area DA and a peripheral area PA outside the display area DA. The display area DA is a portion where an image is displayed, and a plurality of pixels may be arranged in the display area DA. When viewed from a direction substantially perpendicular to the display panel 10, the display area DA may have various suitable shapes, for example, a circular shape, an elliptical shape, a polygonal shape, or the like. As an example, FIG. 1 shows the display area DA having a substantially rectangular shape with rounded corners.

The peripheral area PA may be arranged outside the display area DA. A width (in an x-axis direction) of a portion of the peripheral area PA may be less than a width (in the x-axis direction) of the display area DA. Through this structure, at least a portion of the peripheral area PA may be easily bent as described below.

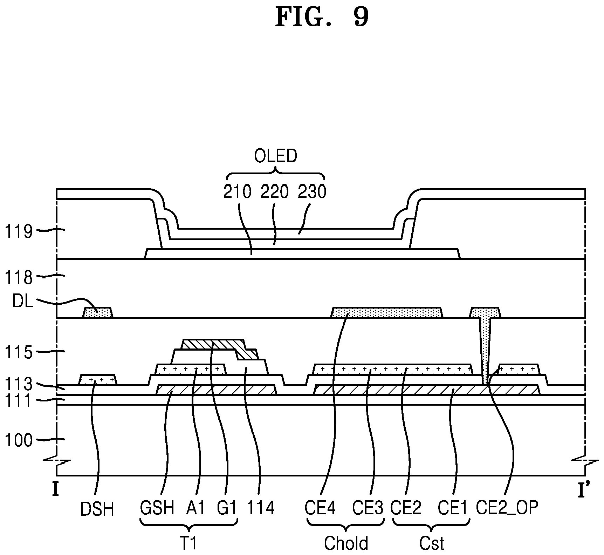

Because the display panel 10 includes a substrate 100 (e.g., refer to FIG. 9), the substrate 100 may be stated to have the display area DA and the peripheral area PA described above. Hereinafter, for convenience of explanation, the substrate 100 will be described as having the display area DA and the peripheral area PA.

The display panel 10 may also be stated to have a main region MR, a bending region BR outside the main region MR, and a sub-region SR opposite to the main region MR with respect to the bending region BR. In the bending region BR, the display panel 10 may be bent as shown in FIG. 2, and thus, at least a portion of the sub-region SR may overlap the main region MR when viewed in a z-axis direction (e.g., the plan view). One or more embodiments are not limited to a bent display apparatus and may also be applied to a display apparatus that is not bent. The sub-region SR may be a non-display area as described below. The display panel 10 may be bent in the bending region BR, and thus, when the display apparatus is viewed from the front (in a direction -z), the non-display area may not be visible, or even when the non-display area is visible, a visible area thereof may be reduced.

A driving chip 20 may be arranged in the sub-region SR of the display panel 10. The driving chip 20 may include an integrated circuit configured to drive the display panel 10. The integrated circuit may be a data driving integrated circuit configured to generate a data signal, but embodiments of the present disclosure are not limited thereto.

The driving chip 20 may be mounted in the sub-region SR of the display panel 10. Although the driving chip 20 is mounted on the same surface as a display surface of the display area DA, the driving chip 20 may be on a rear surface of the main region MR when the display panel 10 is bent in the bending region BR as described above.

A printed circuit board 30, or the like, may be attached to an end portion of the sub-region SR of the display panel 10. The printed circuit board 30, or the like, may be electrically connected to the driving chip 20, and/or the like, through a pad on a substrate.

Although an organic light-emitting display apparatus is described below as an example of a display apparatus, the display apparatus described herein is not limited thereto. In some other examples, the display apparatus described herein may be a display apparatus, such as an inorganic light-emitting display (or an inorganic electroluminescent (EL) display) or a quantum dot light-emitting display. For example, an emission layer of a display element included in the display apparatus may include an organic material or an inorganic material. Also, the display apparatus may include an emission layer, and a quantum dot layer on a path of light emitted from the emission layer.

A plurality of pixels are in the display area DA. Each of the plurality of pixels may include a plurality of sub-pixels, and each of the plurality of sub-pixels may include a display element, such as an organic light-emitting diode (OLED). The sub-pixel may emit, for example, red, green, blue, or white light.

The sub-pixel may be electrically connected to outer circuits arranged in the peripheral area PA. A scan driving circuit, an emission control driving circuit, a terminal, a first power supply wire, and a second power supply wire may be arranged in the peripheral area PA. The scan driving circuit may be configured to provide a scan signal to the pixel through a scan line. The emission control driving circuit may be configured to provide an emission control signal to the pixel through an emission control line. The terminal arranged in the peripheral area PA may not be covered by an insulating layer but may be exposed and electrically connected to the printed circuit board 30. A terminal of the printed circuit board 30 may be electrically connected to a terminal of the display panel 10.

The printed circuit board 30 is configured to transmit a signal or power of a controller to the display panel 10. A control signal generated by the controller may be transmitted to each of the driving circuits through the printed circuit board 30. Also, the controller may provide a driving power voltage ELVDD (or a driving voltage) to the first power supply wire and may provide a common power voltage ELVSS to the second power supply wire.

The controller may generate a data signal, and the generated data signal may be transmitted to the sub-pixel through the driving chip 20 and a data line.

For reference, the term "line" may denote a "wire." This also applies to the following embodiments and modifications thereof.

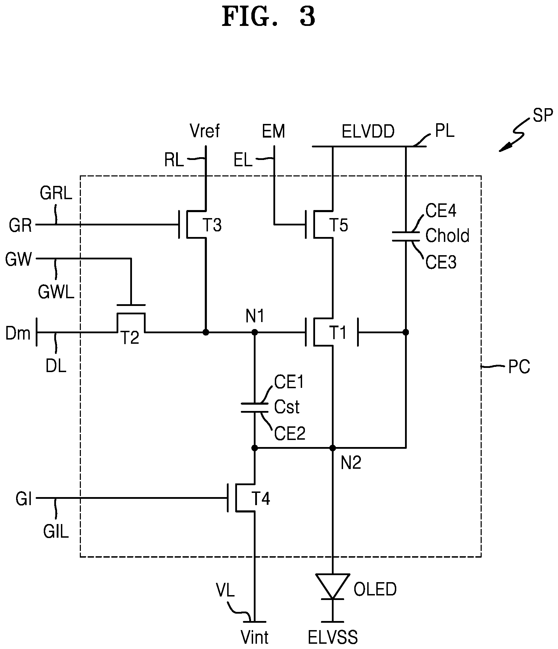

FIG. 3 is an equivalent circuit diagram of a sub-pixel SP included in the display apparatus of FIG. 1, according to some embodiments of the present disclosure. As shown in FIG. 3, the sub-pixel SP may include a pixel circuit PC and an organic light-emitting diode OLED electrically connected thereto.

As shown in FIG. 3, the pixel circuit PC may include a plurality of thin-film transistors T1 to T5, a first capacitor Cst, and a second capacitor Chold. The plurality of thin-film transistors T1 to T5, the first capacitor Cst, and the second capacitor Chold may be connected to signal lines GWL, GRL, GIL, EL, and DL, an initialization voltage line VL, a reference voltage line RL, and a driving voltage line PL.

The plurality of thin-film transistors T1 to T5 may include a driving transistor T1, a switching transistor T2, a reference voltage transistor T3, an initialization transistor T4, and an emission control transistor T5.

The organic light-emitting diode OLED may include a pixel electrode 210 (e.g., refer to FIG. 9) and an opposite electrode 230 (e.g., refer to FIG. 9), and the pixel electrode 210 of the organic light-emitting diode OLED may be connected to the driving transistor T1 to receive a driving current, and the opposite electrode 230 may receive the common power voltage ELVSS. The organic light-emitting diode OLED may generate light having a luminance corresponding to the driving current.

The plurality of thin-film transistors T1 to T5 may be n-channel MOSFETs (NMOSs). The plurality of thin-film transistors T1 to T5 may include an oxide semiconductor material.

The signal lines may include a first scan line GWL configured to transmit a first scan signal GW, a second scan line GRL configured to transmit a second scan signal GR, a third scan line GIL configured to transmit a third scan signal GI, an emission control line EL configured to transmit an emission control signal EM, and a data line DL crossing the first scan line GWL and configured to transmit a data signal Dm.

The initialization voltage line VL may be configured to transfer an initialization voltage Vint for initializing a pixel electrode of the organic light-emitting diode OLED, the reference voltage line RL may be configured to transfer a reference voltage Vref to a driving gate electrode of the driving transistor T1, and the driving voltage line PL may be configured to transfer the driving power voltage ELVDD, which is a driving voltage, to the driving transistor T1.

A driving gate electrode of the driving transistor T1 may be connected to the first or storage capacitor Cst through a first node N1, a drain region of the driving transistor T1 may be connected to the driving voltage line PL via the emission control transistor T5, and a source region of the driving transistor T1 may be electrically connected to the pixel electrode 210 of the organic light-emitting diode OLED through a second node N2. The driving transistor T1 may be configured to receive the data signal Dm according to a switching operation of the switching transistor T2 and supply a driving current to the organic light-emitting diode OLED. That is, the driving transistor T1 may be configured to control an amount of current flowing to the organic light-emitting diode OLED, in response to a voltage applied to the first node N1, the voltage varying due to the data signal Dm.

A switching gate electrode of the switching transistor T2 may be connected to the first scan line GWL that is configured to transmit the first scan signal GW, one of a source region and a drain region of the switching transistor T2 may be connected to the data line DL, and the other of the source region and the drain region of the switching transistor T2 may be connected to the driving gate electrode of the driving transistor T1 through the first node N1. The switching transistor T2 may be configured to transmit the data signal Dm from the data line DL to the first node N1, in response to a voltage applied to the first scan line GWL. That is, the switching transistor T2 may be turned on according to the first scan signal GW received through the first scan line GWL and thus may perform a switching operation in which the data signal Dm transmitted through the data line DL is transmitted to the driving transistor T1 through the first node N1.

A reference voltage gate electrode of the reference voltage transistor T3 may be connected to the second scan line GRL that is configured to transmit the second scan signal GR, one of a source electrode and a drain electrode of the reference voltage transistor T3 may be connected to the reference voltage line RL, and the other of the source electrode and the drain electrode of the reference voltage transistor T3 may be connected to the driving gate electrode of the driving transistor T1 through the first node N1. The reference voltage transistor T3 may transfer the reference voltage Vref from the reference voltage line RL to the first node N1, in response to a voltage applied to the second scan line GRL. In some examples, the second scan line GRL may be the first scan line GWL in a sub-pixel belonging to a previous row adjacent to the sub-pixel SP shown in FIG. 3 and electrically connected to the same data line DL. In this regard, the second scan signal GR may be referred to as a previous writing signal (or a previous scan signal).

An initialization gate electrode of the initialization transistor T4 may be connected to the third scan line GIL, one of a source region and a drain region of the initialization transistor T4 may be connected to the pixel electrode 210 of the organic light-emitting diode OLED through the second node N2, and the other of the source region and the drain region of the initialization transistor T4 may be connected to the initialization voltage line VL to receive the initialization voltage Vint. The initialization transistor T4 is turned on according to the third scan signal GI received through the third scan line GIL to initialize the pixel electrode 210 of the organic light-emitting diode OLED. In some examples, the third scan line GIL may be the first scan line GWL in a sub-pixel belonging to a next row adjacent to the sub-pixel SP shown in FIG. 3 and electrically connected to the same data line DL. In this regard, the third scan signal GI may be referred to as a next writing signal (or a next scan signal).

An emission control gate electrode of the emission control transistor T5 may be connected to the emission control line EL, one of a source region and a drain region of the emission control transistor T5 may be connected to the driving voltage line PL, and the other may be connected to the drain region of the driving transistor T1. As the emission control transistor T5 is turned on according to the emission control signal EM received through the emission control line EL, the driving power voltage ELVDD is transferred to the organic light-emitting diode OLED, and thus, a driving current flows through the organic light-emitting diode OLED.

The first capacitor Cst is a storage capacitor and may include a first capacitor electrode CE1 and a second capacitor electrode CE2 spaced from the first capacitor electrode CE1. The first capacitor electrode CE1 of the first capacitor Cst is connected to the driving gate electrode of the driving transistor T1 through the first node N1, and the second capacitor electrode CE2 of the first capacitor Cst is connected to the source region of the driving transistor T1 through the second node N2. The first capacitor Cst may store a charge corresponding to a difference between a driving gate electrode voltage of the driving transistor T1 and the initialization voltage Vint.

The second capacitor Chold is a holding capacitor and may include a third capacitor electrode CE3 and a fourth capacitor electrode CE4 spaced from the third capacitor electrode CE3. The third capacitor electrode CE3 of the second capacitor Chold may be connected to the source region of the driving transistor T1 through the second node N2, and the fourth capacitor electrode CE4 of the second capacitor Chold may be connected to the driving voltage line PL. A compensation voltage for compensating for a threshold voltage Vth of the driving transistor T1 may be stored in the second capacitor Chold.

Detailed operations of each sub-pixel SP according to some embodiments are as follows.

During an initialization period, when the third scan signal GI is supplied through the third scan line GIL, the initialization transistor T4 is turned on, and the pixel electrode 210 of the organic light-emitting diode OLED is initialized by the initialization voltage Vint supplied from the initialization voltage line VL. The source region of the driving transistor T1 electrically connected to the pixel electrode 210 of the organic light-emitting diode OLED by the second node N2 and the third capacitor electrode CE3 of the second capacitor Chold are also initialized. As described above, the third scan line GIL may be the first scan line GWL in a sub-pixel belonging to a next row adjacent to the sub-pixel SP shown in FIG. 3 and electrically connected to the same data line DL. In this case, the third scan signal GI may be referred to as a next writing signal (or a next scan signal).

During a compensation period, when the second scan signal GR is supplied through the second scan line GRL, the reference voltage transistor T3 is turned on, and the reference voltage Vref supplied from the reference voltage line RL is transferred to a driving gate electrode of the driving transistor T1 to compensate for the threshold voltage Vth of the driving transistor T1. A compensation voltage for compensating for the threshold voltage Vth of the driving transistor T1 is stored in the second capacitor Chold. As described above, in some examples, the second scan line GRL may be the first scan line GWL in a sub-pixel belonging to a previous row adjacent to the sub-pixel SP shown in FIG. 3 and electrically connected to the same data line DL. In this regard, the second scan signal GR may be referred to as a previous writing signal (or a previous scan signal).

During a data programming period, when the first scan signal GW is supplied through the first scan line GWL, the switching transistor T2 is turned on in response to the first scan signal GW. Then, a voltage corresponding to the data signal Dm supplied from the data line DL is applied to the driving gate electrode of the driving transistor T1. Because the first capacitor electrode CE1 of the first capacitor Cst is connected to the driving gate electrode of the driving transistor T1 through the first node N1, and the second capacitor electrode CE2 of the first capacitor Cst is connected to a third capacitor electrode CE3 of the second capacitor Chold storing a compensation voltage for which the threshold voltage Vth of the driving transistor T1 is compensated through the second node N2, a data voltage for which the threshold voltage Vth of the driving transistor T1 is compensated is stored in the first capacitor Cst.

During an emission period, the emission control transistor T5 is turned on by the emission control signal EM supplied from the emission control line EL. Because the first capacitor electrode CE1 of the first capacitor Cst is connected to the driving gate electrode of the driving transistor T1 through the first node N1, and the second capacitor electrode CE2 of the first capacitor Cst is connected to the source region of the driving transistor T1 through the second node N2, a driving current corresponding to the data signal Dm regardless of the threshold voltage Vth of the driving transistor T1 due to the data voltage stored in the first capacitor Cst, for which the threshold voltage Vth of the driving transistor T1 is compensated, flows through the organic light-emitting diode OLED.

As described above, the plurality of thin-film transistors T1 to T5 may include an oxide semiconductor material. Because an oxide semiconductor has high carrier mobility and a low leakage current, a voltage drop is not great even when a driving time is long. That is, in the case of an oxide semiconductor, a color change of an image due to a voltage drop is not great even during low-frequency driving, which makes low-frequency driving possible. Accordingly, the plurality of thin-film transistors T1 to T5 may include an oxide semiconductor material, thereby implementing a display apparatus in which leakage current is prevented or substantially reduced and power consumption is reduced.

Because such an oxide semiconductor is sensitive to light, variations in an amount of current and the like may occur due to light from the outside. Accordingly, it may be considered to absorb or reflect light from the outside by placing a metal layer below the oxide semiconductor. Thus, as shown in FIG. 3, the driving transistor T1 including an oxide semiconductor layer may have a metal layer below the oxide semiconductor layer. That is, when viewed from a direction perpendicular to a top surface of the substrate 100 (e.g., a z-axis direction), the metal layer below the oxide semiconductor may overlap the oxide semiconductor.

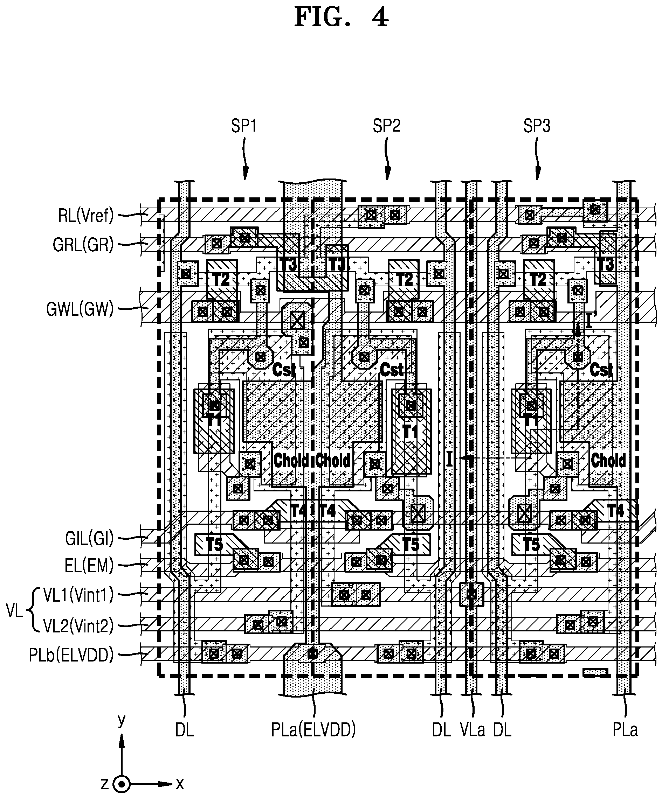

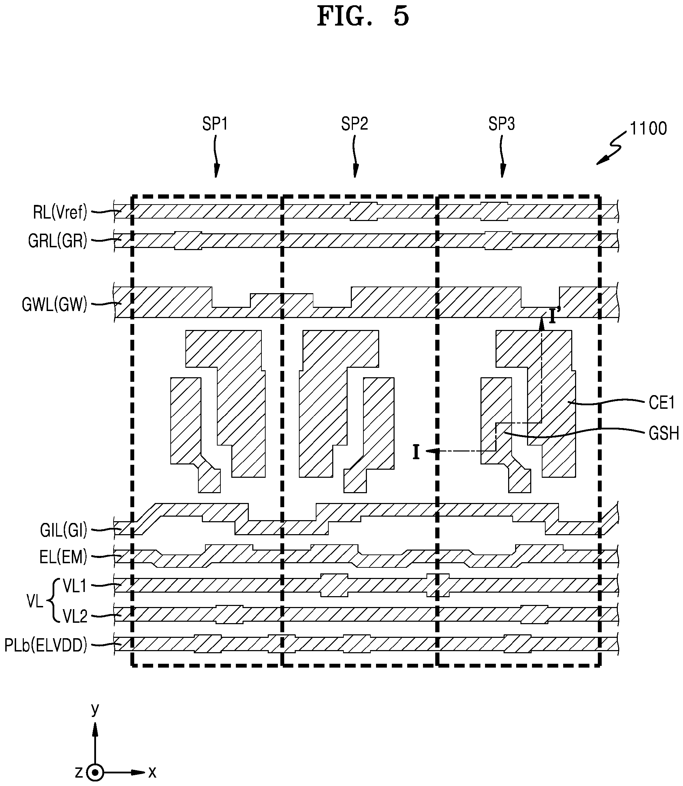

FIG. 4 is a layout diagram schematically showing locations of the thin-film transistors T1 to T5, the first capacitor Cst, and the second capacitor Chold in sub-pixels included in the display apparatus of FIG. 1, according to some embodiments of the present disclosure. FIGS. 5 to 8 are layout diagrams schematically showing elements, such as the thin-film transistors T1 to T5, the first capacitor Cst, and the second capacitor Chold of the display apparatus shown in FIG. 4, layer by layer, according to some embodiments of the present disclosure. FIG. 9 is a schematic cross-sectional view of the display apparatus shown in FIG. 4, taken along the line I-I' of FIG. 4, according to some embodiments of the present disclosure.

As shown in FIGS. 4 to 8, the display apparatus may include pixels, and each of the pixels may include a first sub-pixel SP1, a second sub-pixel SP2, and a third sub-pixel SP3. For example, the first sub-pixel SP1 may be a red sub-pixel emitting red light, the second sub-pixel SP2 may be a green sub-pixel emitting green light, and the third sub-pixel SP3 may be a blue sub-pixel emitting blue light. However, embodiments of the present disclosure are not limited thereto, and one pixel may include fewer sub-pixels or more sub-pixels.

The structures shown in FIGS. 4 to 8 may be repeatedly arranged in a first direction (e.g., an x-axis direction) and/or a second direction (e.g., a y-axis direction). The first direction may be perpendicular to the second direction.

Each of the first to third sub-pixels SP1 to SP3 may include a pixel circuit. Hereinafter, some elements will be described for convenience of explanation with reference to the pixel circuit of the third sub-pixel SP3, but these elements may also be arranged in the pixel circuit of each of the first sub-pixel SP1 and the second sub-pixel SP2.

The substrate 100 (e.g., refer to FIG. 9) may be a single layer of a glass material. In some examples, the substrate 100 may include polymer resin. The substrate 100 including polymer resin may have a structure in which a layer including polymer resin and an inorganic layer are stacked. In some embodiments, the substrate 100 includes polymer resin, such as polyethersulfone, polyarylate, polyetherimide, polyethylene naphthalate, polyethylene terephthalate, polyphenylene sulfide, polyimide, polycarbonate, cellulose triacetate, cellulose acetate propionate, and/or the like, and may be flexible. The substrate 100 may include glass (e.g., mainly including silicon dioxide or silica SiO₂) or resin such as reinforced plastic, and may be rigid.

A first buffer layer 111 (e.g., refer to FIG. 9) including silicon oxide, silicon nitride, silicon oxynitride, and/or the like may be on the substrate 100. The first buffer layer 111 may planarize a top surface of the substrate 100.

A bottom metal layer 1100 as shown in FIG. 5 may be disposed on the first buffer layer 111. The bottom metal layer 1100 may include the reference voltage line RL that is configured to transfer the reference voltage Vref, the second scan line GRL that is configured to transmit the second scan signal GR, the first scan line GWL that is configured to transmit the first scan signal GW, the emission control line EL that is configured to transmit the emission control signal EM, a horizontal driving voltage line PLb that is configured to transfer the driving power voltage ELVDD, the third scan line GIL that is configured to transmit the third scan signal GI, the initialization voltage line VL that is configured to transfer the initialization voltage Vint, the first capacitor electrode CE1, and a driving shield layer GSH.

Among them, the reference voltage line RL, the second scan line GRL, the first scan line GWL, the emission control line EL, the horizontal driving voltage line PLb, the third scan line GIL, and the initialization voltage line VL may extend in the first direction (e.g., the x-axis direction).

The initialization voltage line VL may include a first initialization voltage line VL1 and a second initialization voltage line VL2. The first initialization voltage line VL1 may be configured to transfer a first initialization voltage Vint1 to the second sub-pixel SP2, and the second initialization voltage line VL2 may be configured to transfer a second initialization voltage Vint2 to the first sub-pixel SP1 and the third sub-pixel SP3. In some embodiments, the first initialization voltage Vint1 and the second initialization voltage Vint2 have different values from each other. In some embodiments, the first initialization voltage Vint1 has a smaller value than the second initialization voltage Vint2. For example, the first initialization voltage Vint1 may be about -3.5 V, and the second initialization voltage Vint2 may be about -2 V.

The first capacitor electrode CE1 may have an isolated shape. The first capacitor electrode CE1, which is one electrode of the first capacitor Cst of FIG. 3, may overlap (e.g., in a plan view) the second capacitor electrode CE2 provided as a semiconductor layer 1200 and thus may together form (e.g., constitute) the first capacitor Cst along with the second capacitor electrode CE2.

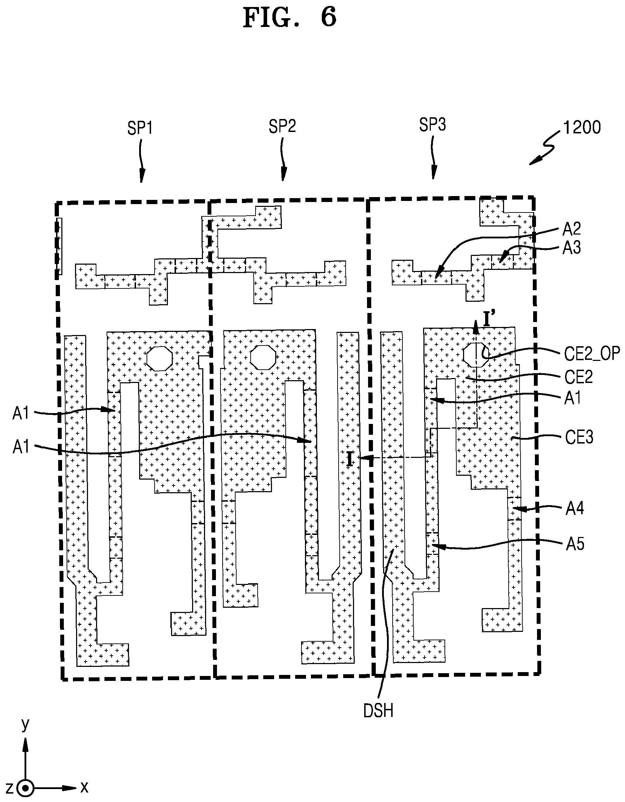

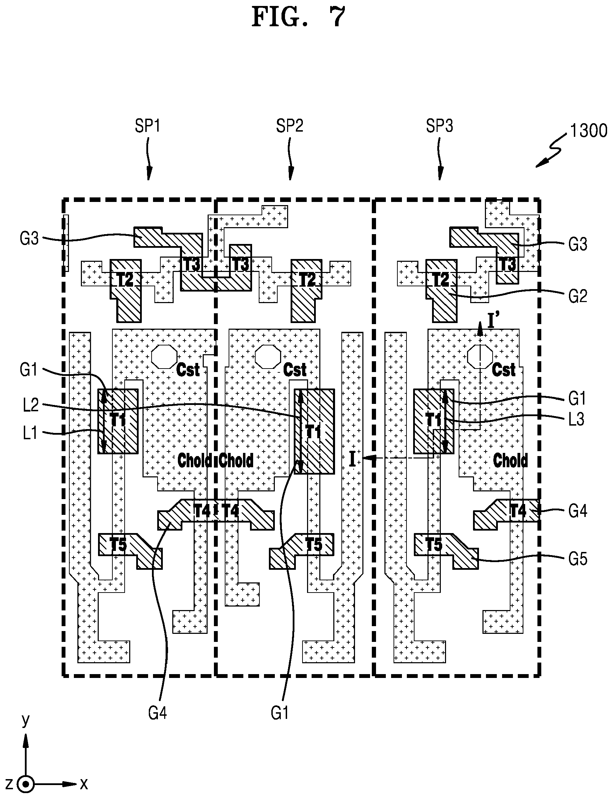

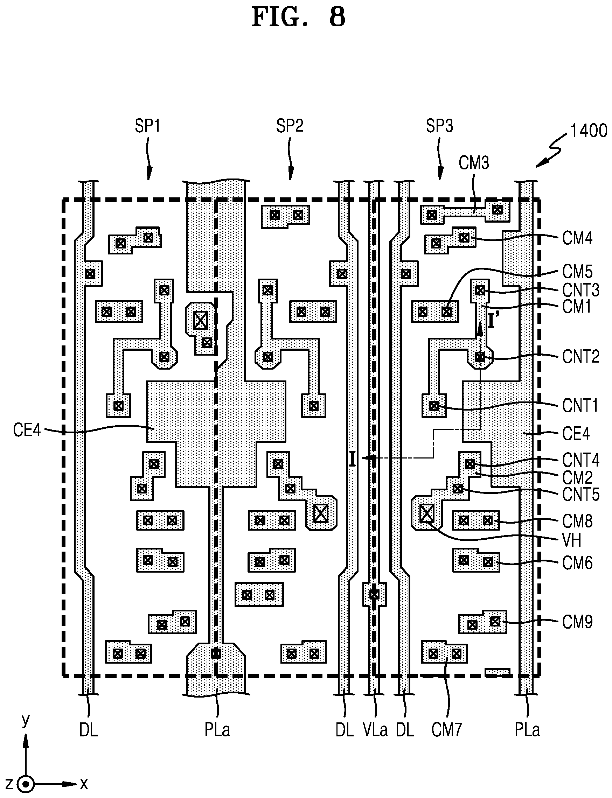

The driving shield layer GSH may have an isolated shape like the first capacitor electrode CE1. The driving shield layer GSH may overlap a driving gate electrode G1 (e.g., refer to FIG. 7) and a driving active region A1 (e.g., refer to FIG. 6) described below and thus may prevent or reduce the incidence of light from the outside onto the driving active region A1. Also, the driving shield layer GSH may be electrically connected to the second capacitor electrode CE2 (e.g., refer to FIG. 6) through a second connection electrode CM2 (e.g., refer to FIG. 8). Thus, because a voltage stored in the first capacitor Cst is applied to the driving shield layer GSH, the driving shield layer GSH may protect the driving active region A1 from an unintended electrical signal from the outside. The driving shield layer GSH may be a bottom driving gate electrode.

The bottom metal layer 1100 may include a metal, an alloy, a conductive metal oxide, and/or the like. For example, the bottom metal layer 1100 may include silver (Ag), alloy containing silver, molybdenum (Mo), alloy containing molybdenum, aluminum (Al), alloy containing aluminum, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), and/or the like. The bottom metal layer 1100 may have a multi-layer structure.

A second buffer layer 113 (e.g., refer to FIG. 9) may cover the bottom metal layer 1100 and may be disposed above the substrate 100. The second buffer layer 113 may include an insulating material. For example, the second buffer layer 113 may include silicon oxide, silicon nitride, or silicon oxynitride. The second buffer layer 113 may prevent diffusion of metal atoms or impurities from the substrate 100 into the semiconductor layer 1200 thereon, or substantially reduce instances thereof.

The semiconductor layer 1200 as shown in FIG. 6 may be disposed on the second buffer layer 113. As described above, the semiconductor layer 1200 may include an oxide semiconductor material. For example, the semiconductor layer 1200 may include ITGZO having a thickness of about 300 Å. The driving transistor T1, the switching transistor T2, the reference voltage transistor T3, the initialization transistor T4, the emission control transistor T5, the first capacitor Cst, and the second capacitor Chold are located along the semiconductor layer 1200 shown in FIG. 6.

In FIG. 6, the semiconductor layer 1200 may include a first portion and a second portion spaced apart from each other, and a switching active region A2 of the switching transistor T2 and a reference voltage active region A3 of the reference voltage transistor T3 are located in the first portion, and the driving active region A1 of the driving transistor T1, an initialization active region A4 of the initialization transistor T4, an emission control active region A5 of the emission control transistor T5, the second capacitor electrode CE2, the third capacitor electrode CE3, and a data shield layer DSH are located in the second portion.

In some embodiments, the driving active region A1 has the shape of a straight line extending in the second direction (e.g., a y-axis direction). In some embodiments, at least one of the lengths of respective driving active regions A1 of the first sub-pixel SP1, the second sub-pixel SP2, and the third sub-pixel SP3 are different. For example, a length of the driving active region A1 of the second sub-pixel SP2 may be greater than a length of the driving active region A1 of the first sub-pixel SP1 and a length of the driving active region A1 of the third sub-pixel SP3. In some embodiments, the length of the driving active region A1 of the first sub-pixel SP1 is the same as the length of the driving active region A1 of the third sub-pixel SP3. In some other embodiments, lengths of respective driving active regions A1 of the first sub-pixel SP1, the second sub-pixel SP2, and the third sub-pixel SP3 are different from one another.

In some embodiments, because the driving active region A1 has the shape of a straight line extending in the second direction, a length of the driving active region A1 is the same as that of the driving gate electrode G1 (e.g., refer to FIG. 7) in the second direction.

The second capacitor electrode CE2 may have an opening CE2_OP having a closed shape. A first connection electrode CM1 (e.g., refer to FIG. 8) described below may be connected to the first capacitor electrode CE1 through the opening CE2_OP. The second capacitor electrode CE2 and the third capacitor electrode CE3 may be integrally formed (e.g., formed as one unitary electrode) with each other.

The data shield layer DSH may overlap (e.g., in a plan view) the data line DL (e.g., refer to FIG. 8) described below. The data shield layer DSH may prevent other transistors from being affected by a data signal provided to the data line DL, or substantially reduce effects of the data signal on the other transistors. The data shield layer DSH may extend as long as a certain length in the second direction (the y-axis direction).

A gate insulating layer 114 (e.g., refer to FIG. 9) may be disposed on the semiconductor layer 1200. The gate insulating layer 114 may include an insulating material. For example, the gate insulating layer 114 may include an inorganic insulating layer, such as silicon oxide, silicon nitride, silicon oxynitride, aluminum oxide, and/or the like. The gate insulating layer 114 may have a multi-layer structure of the inorganic insulating layer. The gate insulating layer 114 may be patterned along the shape of a first conductive layer 1300 disposed thereon.

The first conductive layer 1300 as shown in FIG. 7 may be on the gate insulating layer 114. In FIG. 7, the first conductive layer 1300 is shown together with the semiconductor layer 1200 for convenience of illustration. The first conductive layer 1300 may include the driving gate electrode G1, a switching gate electrode G2, a reference voltage gate electrode G3, an initialization gate electrode G4, and an emission control gate electrode G5. The first conductive layer 1300 may be referred to as a gate layer.

The driving gate electrode G1 may overlap the driving active region A1 of the semiconductor layer 1200. In addition, the driving gate electrode G1 may overlap the driving shield layer GSH of the bottom metal layer 1100.

In some embodiments, the driving gate electrode G1 has a rectangular shape with a horizontal side in the first direction and a vertical side in the second direction (e.g., the y-axis direction). In this regard, at least one of the sizes of respective driving gate electrodes G1 of the first sub-pixel SP1, the second sub-pixel SP2, and the third sub-pixel SP3 may be different from the others.

In some embodiments, at least one of the lengths of respective driving gate electrodes G1 of the first sub-pixel SP1, the second sub-pixel SP2, and the third sub-pixel SP3 in the second direction are different from the others. For example, a length L2 of the driving gate electrode G1 of the second sub-pixel SP2 in the second direction may be greater than a length L1 of the driving gate electrode G1 of the first sub-pixel SP1 and a length L3 of the driving gate electrode G1 of the third sub-pixel SP3. In some embodiments, the length L1 of the driving gate electrode G1 of the first sub-pixel SP1 and the length L3 of the driving gate electrode G1 of the third sub-pixel SP3 are the same as each other. In some other embodiments, the length L1 of the driving gate electrode G1 of the first sub-pixel SP1, the length L2 of the driving gate electrode G2 of the second sub-pixel SP2, and the length L3 of the driving gate electrode G1 of the third sub-pixel SP3 are different from one another.

In some embodiments, the length of the driving gate electrode G1 in the second direction is the same as that of the driving active region A1 (e.g., refer to FIG. 6).

The switching gate electrode G2 may overlap the switching active region A2 of the semiconductor layer 1200. The reference voltage gate electrode G3 may overlap the reference voltage active region A3 of the semiconductor layer 1200. In some embodiments, reference voltage gate electrodes G3 arranged in adjacent sub-pixels are integral with each other as a single body. In FIG. 7, the reference voltage gate electrode G3 of the first sub-pixel SP1 and the reference voltage gate electrode G3 of the second sub-pixel SP2 are shown as being integral with each other as a single, unitary body.

The initialization gate electrode G4 may overlap the initialization active region A4 of the semiconductor layer 1200. In some embodiments, initialization gate electrodes G4 arranged in adjacent sub-pixels are integral with each other as a single, unitary body. In FIG. 7, the initialization gate electrode G4 of the first sub-pixel SP1 and the initialization gate electrode G4 of the second sub-pixel SP2 are shown as being integral with each other as a single, unitary body.

The emission control gate electrode G5 may overlap the emission control active region A5 of the semiconductor layer 1200.

The first conductive layer 1300 may include a metal, an alloy, a conductive metal oxide, a transparent conductive material, and/or the like. For example, the first conductive layer 1300 may include silver (Ag), alloy containing silver, molybdenum (Mo), alloy containing molybdenum, aluminum (Al), alloy containing aluminum, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. The first conductive layer 1300 may have a multi-layer structure.

An interlayer insulating layer 115 (e.g., refer to FIG. 9) may cover the first conductive layer 1300 and may be above the substrate 100. The interlayer insulating layer 115 may include an insulating material. For example, the interlayer insulating layer 115 may include silicon oxide, silicon nitride, silicon oxynitride, aluminum oxide, and/or the like.

A second conductive layer 1400 as shown in FIG. 8 may be on the interlayer insulating layer 115. The second conductive layer 1400 may include the data line DL, a vertical driving voltage line PLa, a vertical initialization line VLa, and the connection electrodes CM1 and CM2. Among them, the data line DL, the vertical driving voltage line PLa, and the vertical initialization line VLa may extend substantially in the second direction (e.g., the y-axis direction). The second conductive layer 1400 may be referred to as a source/drain layer.

The data line DL may be arranged for each sub-pixel SP1, SP2, and SP3. The data line DL may be configured to provide a data signal to each sub-pixel SP1, SP2, and SP3. The data line DL may be connected to one side of the switching active region A2 of the semiconductor layer 1200 therebelow through a contact hole.

The vertical driving voltage line PLa may be configured to transfer the driving power voltage ELVDD. The vertical driving voltage line PLa may be connected to the horizontal driving voltage line PLb extending in the first direction through a contact hole. Thus, the vertical driving voltage line PLa and the horizontal driving voltage line PLb may form a mesh structure.

A portion of the vertical driving voltage line PLa may serve as the fourth capacitor electrode CE4 of the second capacitor Chold. The fourth capacitor electrode CE4 may overlap the third capacitor electrode CE3 provided as the semiconductor layer 1200 and thus may together form (e.g., constitute) the second capacitor Chold.

In some embodiments, fourth capacitor electrodes CE4 arranged in adjacent sub-pixels are integral with each other as a single, unitary body. In FIG. 8, the fourth capacitor electrode CE4 of the first sub-pixel SP1 and the fourth capacitor electrode CE4 of the second sub-pixel SP2 are shown as being integral with each other as a single, unitary body.

The vertical initialization line VLa may not be arranged for each sub-pixel SP1, SP2, and SP3, and only one vertical initialization line VLa may be arranged over the first to third sub-pixels SP1, SP2, and SP3. The vertical initialization line VLa may be connected to the initialization voltage line VL of the bottom metal layer 1100 therebelow through a contact hole. FIG. 4 shows that the vertical initialization line VLa is connected to the first initialization voltage line VL1.

The first connection electrode CM1 is connected to the driving gate electrode G1 through a contact hole CNT1. In addition, the first connection electrode CM1 is connected to the first capacitor electrode CE1 through a contact hole CNT2 passing through the opening CE2_OP in the second capacitor electrode CE2 of the first capacitor Cst. That is, the first connection electrode CM1 electrically connects the first capacitor electrode CE1 of the first capacitor Cst and the driving gate electrode G1 of the driving transistor T1 to each other. In addition, the first connection electrode CM1 may be connected between one side of the reference voltage active region A3 and one side of the switching active region A2 through a contact hole CNT3. The first connection electrode CM1 may serve as the first node N1 of FIG. 3.

The second connection electrode CM2 is connected to the second capacitor electrode CE2 of the first capacitor Cst through a contact hole CNT4. In addition, the second connection electrode CM2 is connected to the driving shield layer GSH through a contact hole CNT5. In addition, the pixel electrode 210 of the organic light-emitting diode OLED described below may be connected to the second connection electrode CM2 through a via hole VH. That is, the second connection electrode CM2 electrically connects the organic light-emitting diode OLED, the first capacitor Cst, and the driving transistor T1 to one another. The second connection electrode CM2 may serve as the second node N2 of FIG. 3.

A third connection electrode CM3 may connect the reference voltage line RL and one side of the reference voltage active region A3 to each other through contact holes. A fourth connection electrode CM4 may connect the second scan line GRL and the reference voltage gate electrode G3 to each other through contact holes. A fifth connection electrode CM5 may connect the first scan line GWL and the switching gate electrode G2 to each other through contact holes. A sixth connection electrode CM6 may connect the emission control line EL and the emission control gate electrode G5 to each other through contact holes. A seventh connection electrode CM7 may connect the horizontal driving voltage line PLb and one side of the emission control active region A5 to each other through contact holes. An eighth connection electrode CM8 may connect the third scan line GIL and the initialization gate electrode G4 to each other through contact holes. A ninth connection electrode CM9 may connect the initialization voltage line VL and one side of the initialization active region A4 to each other through contact holes.

The second conductive layer 1400 may include a metal, an alloy, a conductive metal oxide, a transparent conductive material, and/or the like. For example, the second conductive layer 1400 may include silver (Ag), alloy containing silver, molybdenum (Mo), alloy containing molybdenum, aluminum (Al), alloy containing aluminum, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), and/or the like. The second conductive layer 1400 may have a multi-layer structure.

A via layer 118 may cover the second conductive layer 1400 and may be on the interlayer insulating layer 115. The via layer 118 may include an organic insulating material. For example, the via layer 118 may include a photoresist, a benzocyclobutene (BCB), a polyimide, a hexamethyldisiloxane (HMDSO), a poly(methyl methacrylate) (PMMA), a polystyrene, a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, or a mixture thereof. For example, the via layer 118 may include a polyimide layer having a thickness of about 1.6 µm.

The organic light-emitting diode OLED may be on the via layer 118. The organic light-emitting diode OLED may include the pixel electrode 210, an intermediate layer 220 including an emission layer, and the opposite electrode 230.

The pixel electrode 210 may be a (semi)transmissive electrode or a reflective electrode. For example, the pixel electrode 210 may include a reflective layer including silver (Ag), magnesium (Mg), aluminum (Al), platinum (Pt), palladium (Pd), gold (Au), nickel (Ni), neodymium (Nd), iridium (Ir), chromium (Cr), and a compound thereof, and a transparent or semitransparent electrode layer on the reflective layer. The transparent or semitransparent electrode layer may include at least one selected from the group including indium tin oxide (ITO), indium zinc oxide (IZO), zinc oxide (ZnO), indium oxide (In₂O₃), indium gallium oxide (IGO), and aluminum zinc oxide (AZO). For example, the pixel electrode 210 may have a three-layer structure of ITO/Ag/ITO.

A pixel-defining layer 119 may be disposed on the via layer 118. The pixel-defining layer 119 may prevent an arc, etc. from occurring at the edge of the pixel electrode 210, or substantially reduce instances thereof, by increasing a distance between the edge of the pixel electrode 210 and the opposite electrode 230 above the pixel electrode 210. The pixel-defining layer 119 may include one or more organic insulating materials selected from the group including polyimide, polyamide, acrylic resin, BCB, and phenolic resin, and may be formed by a method, such as spin coating.

At least a portion of the intermediate layer 220 of the organic light-emitting diode OLED may be in an opening formed by the pixel-defining layer 119. An emission area of the organic light-emitting diode OLED may be defined by the opening.

The intermediate layer 220 may include an emission layer. The emission layer may include an organic material including a fluorescent or phosphorescent material that emits red, green, blue, or white light. The emission layer may include a low-molecular weight organic material or a polymer organic material, and functional layers, such as a hole transport layer (HTL), a hole injection layer (HIL), an electron transport layer (ETL), and an electron injection layer (EIL), may be optionally further disposed over and below the emission layer.

The emission layer may have a patterned shape corresponding to each pixel electrode 210. Layers other than the emission layer included in the intermediate layer 220 may have various modifications, such as being integral as a single body over a plurality of pixel electrodes 210.

The opposite electrode 230 may be a transmissive electrode or a reflective electrode. For example, the opposite electrode 230 may be a transparent or semitransparent electrode and may include a metal thin-film with a small work function including Li, Ca, lithium fluoride (LiF), Al, Ag, Mg, and a compound thereof. In addition, the opposite electrode 230 may further include a transparent conductive oxide (TCO) film, such as ITO, IZO, ZnO, or In₂O₃, on the metal thin-film. The opposite electrode 230 may be integrally formed as a single, unitary body over the entire surface of the display area DA and disposed on the intermediate layer 220 and the pixel-defining layer 119.

Configurations of the third sub-pixel SP3 have been mainly described thus far, but a description thereof may also apply to the first sub-pixel SP1 and/or the second sub-pixel SP2. Because a pixel circuit is located in each of the first to third sub-pixels SP1 to SP3, a pixel circuit in the first sub-pixel SP1 may be referred to as a first pixel circuit, a pixel circuit in the second sub-pixel SP2 may be referred to as a second pixel circuit, and a pixel circuit in the third sub-pixel SP3 may be referred to as a third pixel circuit.

Likewise, the driving transistor T1 included in the first sub-pixel SP1 may be referred to as a first driving transistor, the driving transistor T1 included in the second sub-pixel SP2 may be referred to as a second driving transistor, and the driving transistor T1 included in the third sub-pixel SP3 may be referred to as a third driving transistor.

The initialization transistor T4 included in the first sub-pixel SP1 may be referred to as a first initialization transistor, the initialization transistor T4 included in the second sub-pixel SP2 may be referred to as a second initialization transistor, and the initialization transistor T4 included in the third sub-pixel SP3 may be referred to as a third initialization transistor.

The first capacitor Cst and the second capacitor Chold included in the first sub-pixel SP1 may be respectively referred to as a 1-1^{st} capacitor and a 1-2^{nd} capacitor, the first capacitor Cst and the second capacitor Chold included in the second sub-pixel SP2 may be respectively referred to as a 2-1^{st} capacitor and a 2-2^{nd} capacitor, and the first capacitor Cst and the second capacitor Chold included in the third sub-pixel SP3 may be respectively referred to as a 3-1^{st} capacitor and a 3-2^{nd} capacitor.

In some embodiments, the first sub-pixel SP1, the second sub-pixel SP2, and the third sub-pixel SP3 includes display elements emitting light of different colors from one another. In this case, display elements included in respective sub-pixels SP1, SP2, and SP3 may include different materials in the intermediate layer 220 (e.g., refer to FIG. 9).

Thus, change rates of impedance of display elements included in respective sub-pixels SP1, SP2, and SP3 may be different from one another due to external temperature, and accordingly, a difference in luminance changes of colors represented by respective sub-pixels SP1, SP2, and SP3 may occur.

In some embodiments, the lengths (and/or size) of the driving active regions A1, and/or lengths (and/or size) of the driving gate electrodes G1 of the driving transistors T1 included in respective sub-pixels SP1, SP2, and SP3 is adjusted to reduce the influence of external temperature, and thus, a difference in luminance changes of respective sub-pixels SP1, SP2, and SP3 may be reduced.

In some embodiments, when external temperature rises, a change rate of driving current driving the second sub-pixel SP2 is greater than the change rates of driving current that drive the first sub-pixel SP1 and the third sub-pixel SP3. In this case, the length L2 of the driving active region A1 of the second sub-pixel SP2 may be made greater than the lengths L1 and L3 of the driving active regions A1 of the first sub-pixel SP1 and the third sub-pixel SP3 so that the change rate of current may be the same as the change rates of currents of the first sub-pixel SP1 and the third sub-pixel SP3.

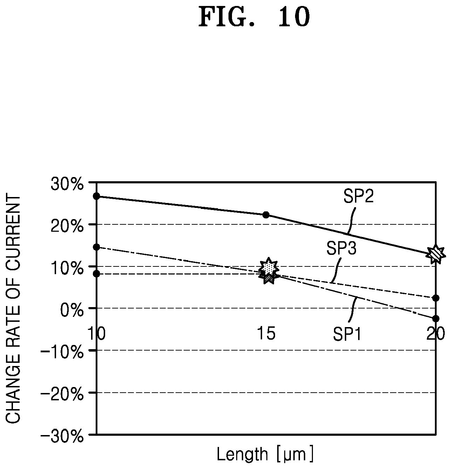

FIG. 10 is a graph simulating a driving current change rate of the first to third sub-pixels SP1, SP2, and SP3 that changes during a temperature rise, according to the length of a driving active region, according to some embodiments of the present disclosure. A case where the temperature rises from 25 °C to 40 °C has been assumed.

Referring to FIG. 10, it may be confirmed that, when the length of a driving active region is 15 µm, the first sub-pixel SP1 and the third sub-pixel SP3 have similar values in terms of a change in current, which is about 8 %, and when the length of a driving active region is 20 µm, the second sub-pixel SP2 has a change in current reduced to about 11 %. As described above, when changes in current according to the temperature are adjusted to be similar by adjusting lengths of driving active regions of the first sub-pixel SP1, the second sub-pixel SP2, and the third sub-pixel SP3, a small difference in luminance may occur according to a temperature change.

The data of FIG. 10 is an example and may vary according to the impedance of display elements included in respective sub-pixels.

Thus, a display apparatus may have various modifications, for example, among a length of a driving active region of the first sub-pixel SP1, a length of a driving active region of the second sub-pixel SP2, and a length of a driving active region of the third sub-pixel SP3, only one may be different, or all may be different.

In addition, in some embodiments, the initialization voltage line VL includes the first initialization voltage line VL1 and the second initialization voltage line VL2 spaced apart from each other. Thus, different initialization voltages may be applied to first to third sub-pixels.

In some embodiments, the first initialization voltage line VL1 is electrically connected to the initialization transistor T4 of one sub-pixel among the first to third sub-pixels SP1, SP2, and SP3, and the second initialization voltage line VL2 may be electrically connected to the initialization transistors T4 of the other two sub-pixels among the first to third sub-pixels SP1, SP2, and SP3.

For example, the first initialization voltage line VL1 may be configured to transfer the first initialization voltage Vint1 to the second sub-pixel SP2, and the second initialization voltage line VL2 may be configured to transfer the second initialization voltage Vint2 to the first sub-pixel SP1 and the third sub-pixel SP3. The first initialization voltage Vint1 may be different from the second initialization voltage Vint2. Thus, initialization voltages applied to pixel electrodes of respective sub-pixels may be different, and accordingly, the luminance of each sub-pixel may be adjusted.

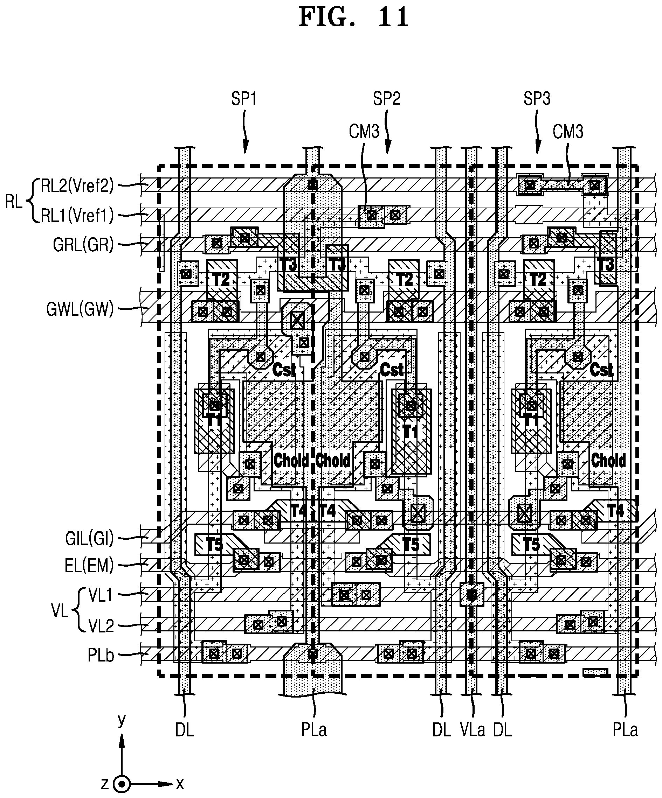

FIG. 11 is a layout diagram schematically showing locations of transistors and capacitors in sub-pixels included in a display apparatus according to some embodiments of the present disclosure. In FIG. 11, the same reference numerals as those in FIG. 4 denote the same elements, and thus, a repeated description thereof is omitted.

Referring to FIG. 11, the display apparatus may include pixels, and each of the pixels may include the first sub-pixel SP1, the second sub-pixel SP2, and the third sub-pixel SP3. The structure shown in FIG. 11 may be repeatedly arranged in a first direction (e.g., an x-axis direction) and/or a second direction (e.g., a y-axis direction).

Each of the first to third sub-pixels SP1 to SP3 may include a pixel circuit. The reference voltage line RL, the second scan line GRL, the first scan line GWL, the emission control line EL, the horizontal driving voltage line PLb, the third scan line GIL, and the initialization voltage line VL may be arranged in the first to third sub-pixels SP1 to SP3, and such wires may extend in a first direction (e.g., an x-axis direction).

In some embodiments, the reference voltage line RL includes a first reference voltage line RL1 and a second reference voltage line RL2. The first reference voltage line RL1 may be electrically connected to the reference voltage transistor T3 of one sub-pixel among the first to third sub-pixels SP1, SP2, and SP3, and the second reference voltage line RL2 may be electrically connected to the reference voltage transistors T3 of the other two sub-pixels among the first to third sub-pixels SP1, SP2, and SP3.

For example, the first reference voltage line RL1 may be configured to transfer a first reference voltage Vref1 to the first sub-pixel SP1 and the second sub-pixel SP2, and the second reference voltage line RL2 may be configured to transfer a second reference voltage Vref2 to the third sub-pixel SP3. The first reference voltage Vref1 and the second reference voltage Vref2 may have different values from each other.

The first reference voltage line RL1 may be connected to the reference voltage transistor T3 of the second sub-pixel SP2 through the third connection electrode CM3 arranged in the second sub-pixel SP2. The second reference voltage line RL2 may be connected to the reference voltage transistor T3 of the third sub-pixel SP3 through the third connection electrode CM3 arranged in the third sub-pixel SP3.

Because the reference voltage line RL is provided in a plurality of numbers, reference voltages may be differentially applied to first to third sub-pixels. Thus, reference voltages applied to respective sub-pixels may be different, and accordingly, the luminance of each sub-pixel may be adjusted.

Although FIG. 11 shows the first reference voltage line RL1 that is configured to transfer the first reference voltage Vref1 to the first sub-pixel SP1 and the second sub-pixel SP2, and the second reference voltage line RL2 configured to transfer the second reference voltage Vref2 to the third sub-pixel SP3, embodiments of the present disclosure are not limited thereto. Various modifications may be made, for example, the first reference voltage line RL1 may be configured to transfer the first reference voltage Vref1 to the first sub-pixel SP1 and the third sub-pixel SP3, and the second reference voltage line RL2 may be configured to transfer the second reference voltage Vref2 to the second sub-pixel SP2.

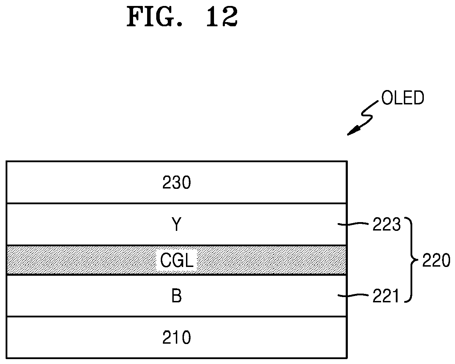

FIGS. 12 to 15 are cross-sectional views briefly showing embodiments of the organic light-emitting diode OLED applicable to some embodiments of the present disclosure.

As described above with reference to FIG. 9, the organic light-emitting diode OLED may be configured to include one emission layer. However, embodiments of the present disclosure are not limited thereto. As shown in FIGS. 12 to 15, the organic light-emitting diode OLED may have a tandem structure in which a plurality of emission layers are stacked.

Referring to FIG. 12, the organic light-emitting diode OLED may include the pixel electrode 210, which is an anode electrode, the opposite electrode 230, which is a cathode electrode, and a first light-emitting unit 221 and a second light-emitting unit 223 stacked between the pixel electrode 210 and the opposite electrode 230. A charge generation layer CGL may be disposed between the first light-emitting unit 221 and the second light-emitting unit 223 of the organic light-emitting diode OLED.

The first light-emitting unit 221 may include a blue emission layer B. A hole injection layer and/or a hole transport layer may be disposed between the pixel electrode 210 and the blue emission layer B. An electron injection layer and/or an electron transport layer may be disposed between the blue emission layer B and the opposite electrode 230.

The second light-emitting unit 223 may include a yellow emission layer Y. A hole injection layer and/or a hole transport layer may be disposed between the charge generation layer CGL and the yellow emission layer Y. An electron injection layer and/or an electron transport layer may be disposed between the yellow emission layer Y and the opposite electrode 230.

The charge generation layer CGL may be disposed between the first light-emitting unit 221 and the second light-emitting unit 223 to control charges between the first light-emitting unit 221 and the second light-emitting unit 223, thereby achieving charge balance.

The charge generation layer CGL may have an n-type layer and a p-type layer stacked on each other, the n-type layer disposed adjacent to the first light-emitting unit 221 to supply electrons to the first light-emitting unit 221 and the p-type layer disposed adjacent to the second light-emitting unit 223 to supply holes to the second light-emitting unit 223.

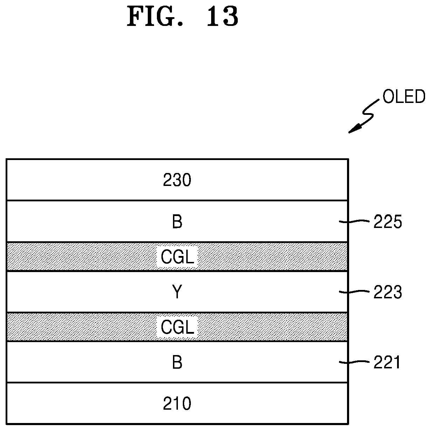

Referring to FIG. 13, the organic light-emitting diode OLED may include the pixel electrode 210, which is an anode electrode, the opposite electrode 230, which is a cathode electrode, and the first light-emitting unit 221, the second light-emitting unit 223, and a third light-emitting unit 225 stacked between the pixel electrode 210 and the opposite electrode 230. The charge generation layer CGL may be disposed between the first light-emitting unit 221 and the second light-emitting unit 223 and between the second light-emitting unit 223 and the third light-emitting unit 225 of the organic light-emitting diode OLED.

The first light-emitting unit 221 may include the blue emission layer B. A hole injection layer and/or a hole transport layer may be disposed under the blue emission layer B, and an electron injection layer and/or an electron transport layer may be disposed on the blue emission layer B.

The second light-emitting unit 223 may include the yellow emission layer Y. A hole injection layer and/or a hole transport layer may be disposed under the yellow emission layer Y, and an electron injection layer and/or an electron transport layer may be disposed on the yellow emission layer Y.

The third light-emitting unit 225 may include the blue emission layer B. A hole injection layer and/or a hole transport layer may be disposed under the blue emission layer B, and an electron injection layer and/or an electron transport layer may be disposed on the blue emission layer B.

The charge generation layer CGL may be disposed between the first to third light-emitting units 221, 223, and 225, and may have an n-type layer and a p-type layer stacked on each other, the n-type layer supplying electrons and the p-type layer supplying holes.

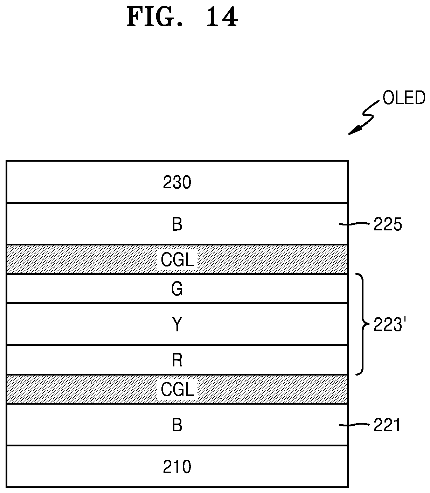

Referring to FIG. 14, the organic light-emitting diode OLED may include the pixel electrode 210, which is an anode electrode, the opposite electrode 230, which is a cathode electrode, and the first light-emitting unit 221, a second light-emitting unit 223', and the third light-emitting unit 225 stacked between the pixel electrode 210 and the opposite electrode 230. The charge generation layer CGL may be disposed between the first light-emitting unit 221 and the second light-emitting unit 223' and between the second light-emitting unit 223' and the third light-emitting unit 225 of the organic light-emitting diode OLED.

The embodiments of FIG. 14 show an example in which the second light-emitting unit 223 has been modified from the embodiments of FIG. 13. The second light-emitting unit 223' may further include a red emission layer R and/or a green emission layer G in addition to the yellow emission layer Y.

Although FIG. 14 shows the red emission layer R disposed under the yellow emission layer Y and the green emission layer G disposed on the yellow emission layer Y, embodiments of the present disclosure are not limited thereto.

For example, the red emission layer R may be disposed on and under the yellow emission layer Y, or the green emission layer G may be disposed on and under the yellow emission layer Y. In some examples, various suitable modifications may be made, for example, the red emission layer R or the green emission layer G may be disposed only on or under the yellow emission layer Y.

The organic light-emitting diode OLED of FIGS. 12 to 14 may be integrally formed as a single, unitary body with respect to a plurality of pixels arranged in the display area DA. In this case, the organic light-emitting diode OLED may emit white light or blue light. A color filter may be disposed on the organic light-emitting diode OLED to implement a color according to each pixel.

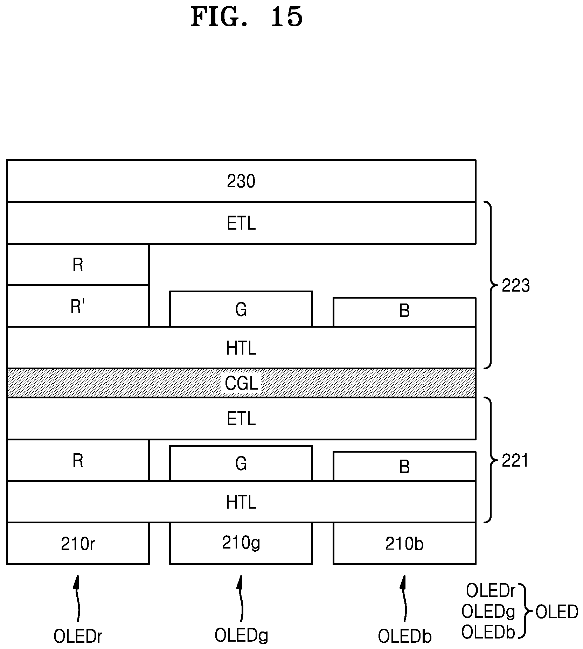

Referring to FIG. 15, the organic light-emitting diode OLED may include a red organic light-emitting diode OLEDr, a green organic light-emitting diode OLEDg, and a blue organic light-emitting diode OLEDb emitting light of different colors from one another.

In some embodiments, all of the red organic light-emitting diode OLEDr, the green organic light-emitting diode OLEDg, and the blue organic light-emitting diode OLEDb have a tandem structure.

The red organic light-emitting diode OLEDr may have a first pixel electrode 210r, the first light-emitting unit 221, the charge generation layer CGL, the second light-emitting unit 223, and the opposite electrode 230 sequentially stacked on one another, the first light-emitting unit 221 including the red emission layer R, and the second light-emitting unit 223 including the red emission layer R and an additional red emission layer R'. The first light-emitting unit 221 and the second light-emitting unit 223 may further include a hole transport layer HTL disposed below the red emission layer R, and an electron transport layer ETL disposed over the red emission layer R.

The green organic light-emitting diode OLEDg may have a second pixel electrode 21 0g, the first light-emitting unit 221, the charge generation layer CGL, the second light-emitting unit 223, and the opposite electrode 230 sequentially stacked on one another, the first light-emitting unit 221 including the green emission layer G, and the second light-emitting unit 223 including the green emission layer G. The first light-emitting unit 221 and the second light-emitting unit 223 may further include the hole transport layer HTL disposed below the green emission layer G, and the electron transport layer ETL disposed over the green emission layer G.

The blue organic light-emitting diode OLEDb may have a third pixel electrode 210b, the first light-emitting unit 221, the charge generation layer CGL, the second light-emitting unit 223, and the opposite electrode 230 sequentially stacked on one another, the first light-emitting unit 221 including the blue emission layer B, and the second light-emitting unit 223 including the blue emission layer B. The first light-emitting unit 221 and the second light-emitting unit 223 may further include the hole transport layer HTL disposed below the blue emission layer B, and the electron transport layer ETL disposed over the blue emission layer B.

The hole transport layer HTL, the electron transport layer ETL, and the charge generation layer CGL may each be integrally formed as a single, unitary body over the red organic light-emitting diode OLEDr, the green organic light-emitting diode OLEDg, and the blue organic light-emitting diode OLEDb. In some embodiments, a separator is arranged between organic light-emitting diodes OLED to improve leakage current caused by the charge generation layer CGL.

In some embodiments, the thicknesses of the red emission layer R, the green emission layer G, and the blue emission layer B included in the red organic light-emitting diode OLEDr, the green organic light-emitting diode OLEDg, and the blue organic light-emitting diode OLEDb are different from one another. This may be set by taking into account a thickness at which light is resonated according to a wavelength emitted from an emission layer. For example, the red emission layer R may be thicker than the green emission layer G. The green emission layer G may be thicker than the blue emission layer B.

Because the organic light-emitting diode OLED has a tandem structure, the organic light-emitting diode OLED may have high luminance, a long lifespan, and the like.

A display apparatus according to some embodiments described above may display a high-quality image with a reduced change in luminance even when external temperature changes.

It will be understood that, although the terms "first", "second", "third", etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section discussed below could be termed a second element, component, region, layer or section, without departing from the scope of the inventive concept.

Spatially relative terms, such as "beneath", "below", "lower", "under", "above", "upper" and the like, may be used herein for ease of description to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. In addition, it will also be understood that when a layer is referred to as being "between" two layers, it can be the only layer between the two layers, or one or more intervening layers may also be present.

The terminology used herein is for the purpose of describing particular embodiments and is not intended to be limiting of the inventive concept. As used herein, the singular forms "a" and "an" are intended to include the plural forms as well, unless the context clearly indicates otherwise. It will be further understood that the terms "include," "including," "comprises," "comprising," "has," "have," and "having," when used in this specification, specify the presence of stated features, integers, steps, operations, elements, and/or components, but do not preclude the presence or addition of one or more other features, integers, steps, operations, elements, components, and/or groups thereof.

As used herein, the term "and/or" includes any and all combinations of one or more of the associated listed items. For example, the expression "A and/or B" denotes A, B, or A and B. Expressions such as "one or more of" and "at least one of," when preceding a list of elements, modify the entire list of elements and do not modify the individual elements of the list. For example, the expression "one or more of A, B, and C," "at least one of A, B, or C," "at least one of A, B, and C," and "at least one selected from the group consisting of A, B, and C" indicates only A, only B, only C, both A and B, both A and C, both B and C, or all of A, B, and C.

Further, the use of "may" when describing embodiments of the inventive concept refers to "one or more embodiments of the inventive concept."

It will be understood that when an element or layer is referred to as being "on", "connected to", "coupled to", or "adjacent" another element or layer, it can be directly on, connected to, coupled to, or adjacent the other element or layer, or one or more intervening elements or layers may be present. When an element or layer is referred to as being "directly on," "directly connected to", "directly coupled to", "in contact with", "in direct contact with", or "immediately adjacent" another element or layer, there are no intervening elements or layers present.

As used herein, the term "substantially," "about," and similar terms are used as terms of approximation and not as terms of degree, and are intended to account for the inherent variations in measured or calculated values that would be recognized by those of ordinary skill in the art.

As used herein, the terms "use," "using," and "used" may be considered synonymous with the terms "utilize," "utilizing," and "utilized," respectively.

It should be understood that embodiments described herein should be considered in a descriptive sense only and not for purposes of limitation. Descriptions of features or aspects within each embodiment should typically be considered as available for other similar features or aspects in some other embodiments. While some embodiments have been described with reference to the figures, it will be understood by those of ordinary skill in the art that various changes in form and details may be made therein without departing from the scope of the present disclosure, as defined by the following claims and equivalents thereof.

Embodiments are set out in the following clauses:
Clause 1 A display apparatus comprising a first sub-pixel, a second sub-pixel, and a third sub-pixel emitting light of different colors from one another, each of the first to third sub-pixels comprising:
   a substrate;
   a driving transistor arranged above the substrate and comprising a semiconductor layer and a driving gate electrode, the semiconductor layer comprising a driving active region;
   a driving shield layer arranged between the substrate and the driving active region;
   a first capacitor comprising a first capacitor electrode and a second capacitor electrode, the first capacitor electrode being arranged on a same layer as the driving shield layer, and the second capacitor electrode being arranged on a same layer as the semiconductor layer; and
   a display element electrically connected to the second capacitor electrode,
   wherein at least one of a length of the driving active region of the first sub-pixel, a length of the driving active region of the second sub-pixel, and a length of the driving active region of the third sub-pixel is different from other ones of the lengths.
Clause 2 The display apparatus of clause 1, wherein each of the first to third sub-pixels further comprises a first scan line arranged on the same layer as the driving shield layer and extending in a first direction, and
   wherein the driving active region extends in a second direction crossing the first direction.
Clause 3 The display apparatus of clause 2, wherein at least one of a length of the driving gate electrode of the first sub-pixel, a length of the driving gate electrode of the second sub-pixel, and a length of the driving gate electrode of the third sub-pixel in the second direction is different from other ones of the lengths.
Clause 4 The display apparatus of any preceding clause, wherein the length of the driving active region of the second sub-pixel is greater than the length of the driving active region of the first sub-pixel and the length of the driving active region of the third sub-pixel.
Clause 5 The display apparatus of clause 4, wherein the length of the driving active region of the first sub-pixel and the length of the driving active region of the third sub-pixel are a same as each other.
Clause 6 The display apparatus of clause 4 or 5, wherein the first sub-pixel is a red pixel, the second sub-pixel is a green pixel, and the third sub-pixel is a blue pixel.
Clause 7 The display apparatus of any preceding clause, wherein each of the first to third sub-pixels further comprises:
   an initialization voltage line arranged on the same layer as the driving shield layer; and
   an initialization transistor connected to the initialization voltage line,
   wherein the initialization voltage line comprises a first initialization voltage line and a second initialization voltage line spaced apart from each other, and
   wherein the first initialization voltage line is electrically connected to the initialization transistor of one sub-pixel among the first to third sub-pixels, and the second initialization voltage line is electrically connected to the initialization transistors of other two sub-pixels among the first to third sub-pixels.
Clause 8 The display apparatus of clause 7, wherein a magnitude of a first initialization voltage transferred through the first initialization voltage line is different from magnitude of a second initialization voltage transferred through the second initialization voltage line.
Clause 9 The display apparatus of any preceding clause, wherein each of the first to third sub-pixels further comprises:
   a reference voltage line arranged on the same layer as the driving shield layer; and
   a reference voltage transistor connected to the reference voltage line,
   wherein the reference voltage line comprises a first reference voltage line and a second reference voltage line spaced apart from each other.
Clause 10 The display apparatus of clause 9, wherein the first reference voltage line is electrically connected to the reference voltage transistor of one sub-pixel among the first to third sub-pixels, and the second reference voltage line is electrically connected to the reference voltage transistors of other two sub-pixels among the first to third sub-pixels.
Clause 11 A display apparatus comprising:
   a substrate;
   a first sub-pixel comprising a first pixel circuit comprising a first driving transistor and a first initialization transistor, the first driving transistor being arranged above the substrate and comprising a first semiconductor layer, the first semiconductor layer comprising a first driving active region and a first driving gate electrode;
   a second sub-pixel comprising a second pixel circuit comprising a second driving transistor and a second initialization transistor, the second driving transistor being arranged above the substrate and comprising a second semiconductor layer, the second semiconductor layer comprising a second driving active region and a second driving gate electrode; and
   a horizontal driving voltage line arranged between the substrate and the first semiconductor layer, extending in a first direction, and electrically connected to the first sub-pixel and the second sub-pixel,
   wherein a size of the first driving gate electrode is different from a size of the second driving gate electrode.
Clause 12 The display apparatus of clause 11, wherein a length of the first driving gate electrode in a second direction crossing the first direction is different from a length of the second driving gate electrode in the second direction.
Clause 13 The display apparatus of clause 11 or 12, wherein a length of the first driving active region is different from a length of the second driving active region.
Clause 14 The display apparatus of any of clauses 11 to 13, further comprising:
   a third sub-pixel comprising a third pixel circuit comprising a third driving transistor and a third initialization transistor, the third driving transistor being arranged above the substrate and comprising a third semiconductor layer, the third semiconductor layer comprising a third driving active region and a third driving gate electrode,
   wherein a size of the third driving gate electrode is a same as the size of the first driving gate electrode.
Clause 15 The display apparatus of clause 14, wherein the first sub-pixel is a red pixel, the second sub-pixel is a green pixel, and the third sub-pixel is a blue pixel.
Clause 16 The display apparatus of clause 15, wherein a length of the second driving active region is greater than a length of the first driving active region and a length of the third driving active region.
Clause 17 The display apparatus of clause 16, further comprising a first initialization voltage line and a second initialization voltage line arranged between the substrate and the first semiconductor layer and extending in the first direction,
   wherein the first initialization voltage line is electrically connected to the second initialization transistor, and the second initialization voltage line is electrically connected to the first initialization transistor and the third initialization transistor.
Clause 18 The display apparatus of clause 16, further comprising a first initialization voltage line and a second initialization voltage line arranged between the substrate and the first semiconductor layer and extending in the first direction,
   wherein the first initialization voltage line is electrically connected to the second initialization transistor, and the second initialization voltage line is electrically connected to the first initialization transistor.
Clause 19 The display apparatus of any of clauses 11 to 18, further comprising a first reference voltage line and a second reference voltage line arranged between the substrate and the first semiconductor layer and extending in the first direction,
   wherein the first reference voltage line is electrically connected to the first sub-pixel, and the second reference voltage line is electrically connected to the second sub-pixel.
Clause 20 The display apparatus of any of clauses 11 to 19, wherein the first semiconductor layer comprises an oxide semiconductor material.

## Claims

1. A display apparatus comprising a first sub-pixel, a second sub-pixel, and a third sub-pixel emitting light of different colors from one another, each of the first to third sub-pixels comprising:
a substrate;
a driving transistor arranged above the substrate and comprising a semiconductor layer and a driving gate electrode, the semiconductor layer comprising a driving active region;
a driving shield layer arranged between the substrate and the driving active region;
a first capacitor comprising a first capacitor electrode and a second capacitor electrode, the first capacitor electrode being arranged on a same layer as the driving shield layer, and the second capacitor electrode being arranged on a same layer as the semiconductor layer; and
a display element electrically connected to the second capacitor electrode,
wherein at least one of a length of the driving active region of the first sub-pixel, a length of the driving active region of the second sub-pixel, and a length of the driving active region of the third sub-pixel is different from other ones of the lengths.

2. The display apparatus of claim 1, wherein each of the first to third sub-pixels further comprises a first scan line arranged on the same layer as the driving shield layer and extending in a first direction, and
wherein the driving active region extends in a second direction crossing the first direction, and optionally
wherein at least one of a length of the driving gate electrode of the first sub-pixel, a length of the driving gate electrode of the second sub-pixel, and a length of the driving gate electrode of the third sub-pixel in the second direction is different from other ones of the lengths.

3. The display apparatus of any preceding claim, wherein the length of the driving active region of the second sub-pixel is greater than the length of the driving active region of the first sub-pixel and the length of the driving active region of the third sub-pixel.

4. The display apparatus of claim 3, wherein the length of the driving active region of the first sub-pixel and the length of the driving active region of the third sub-pixel are a same as each other.

5. The display apparatus of claim 3 or 4, wherein the first sub-pixel is a red pixel, the second sub-pixel is a green pixel, and the third sub-pixel is a blue pixel.

6. The display apparatus of any preceding claim, wherein each of the first to third sub-pixels further comprises:
an initialization voltage line arranged on the same layer as the driving shield layer; and
an initialization transistor connected to the initialization voltage line,
wherein the initialization voltage line comprises a first initialization voltage line and a second initialization voltage line spaced apart from each other, and
wherein the first initialization voltage line is electrically connected to the initialization transistor of one sub-pixel among the first to third sub-pixels, and the second initialization voltage line is electrically connected to the initialization transistors of other two sub-pixels among the first to third sub-pixels, and optionally
wherein a magnitude of a first initialization voltage transferred through the first initialization voltage line is different from magnitude of a second initialization voltage transferred through the second initialization voltage line.

7. The display apparatus of any preceding claim, wherein each of the first to third sub-pixels further comprises:
a reference voltage line arranged on the same layer as the driving shield layer; and
a reference voltage transistor connected to the reference voltage line,
wherein the reference voltage line comprises a first reference voltage line and a second reference voltage line spaced apart from each other, and optionally
wherein the first reference voltage line is electrically connected to the reference voltage transistor of one sub-pixel among the first to third sub-pixels, and the second reference voltage line is electrically connected to the reference voltage transistors of other two sub-pixels among the first to third sub-pixels.

8. A display apparatus comprising:
a substrate;
a first sub-pixel comprising a first pixel circuit comprising a first driving transistor and a first initialization transistor, the first driving transistor being arranged above the substrate and comprising a first semiconductor layer, the first semiconductor layer comprising a first driving active region and a first driving gate electrode;
a second sub-pixel comprising a second pixel circuit comprising a second driving transistor and a second initialization transistor, the second driving transistor being arranged above the substrate and comprising a second semiconductor layer, the second semiconductor layer comprising a second driving active region and a second driving gate electrode; and
a horizontal driving voltage line arranged between the substrate and the first semiconductor layer, extending in a first direction, and electrically connected to the first sub-pixel and the second sub-pixel,
wherein a size of the first driving gate electrode is different from a size of the second driving gate electrode.

9. The display apparatus of claim 8, wherein a length of the first driving gate electrode in a second direction crossing the first direction is different from a length of the second driving gate electrode in the second direction, or wherein a length of the first driving active region is different from a length of the second driving active region.

10. The display apparatus of claim 8, further comprising:
a third sub-pixel comprising a third pixel circuit comprising a third driving transistor and a third initialization transistor, the third driving transistor being arranged above the substrate and comprising a third semiconductor layer, the third semiconductor layer comprising a third driving active region and a third driving gate electrode,
wherein a size of the third driving gate electrode is a same as the size of the first driving gate electrode.

11. The display apparatus of claim 10, wherein the first sub-pixel is a red pixel, the second sub-pixel is a green pixel, and the third sub-pixel is a blue pixel.

12. The display apparatus of claim 11, wherein a length of the second driving active region is greater than a length of the first driving active region and a length of the third driving active region, and optionally
wherein the display apparatus further comprises a first initialization voltage line and a second initialization voltage line arranged between the substrate and the first semiconductor layer and extending in the first direction, wherein the first initialization voltage line is electrically connected to the second initialization transistor, and the second initialization voltage line is electrically connected to the first initialization transistor and the third initialization transistor.

13. The display apparatus of claim 8, further comprising a first initialization voltage line and a second initialization voltage line arranged between the substrate and the first semiconductor layer and extending in the first direction,
wherein the first initialization voltage line is electrically connected to the second initialization transistor, and the second initialization voltage line is electrically connected to the first initialization transistor.

14. The display apparatus of claim 8, further comprising a first reference voltage line and a second reference voltage line arranged between the substrate and the first semiconductor layer and extending in the first direction,
wherein the first reference voltage line is electrically connected to the first sub-pixel, and the second reference voltage line is electrically connected to the second sub-pixel.

15. The display apparatus of claim 8, wherein the first semiconductor layer comprises an oxide semiconductor material.
